(19) Europäisches Patentamt
European Patent Office
Office européen des brevets

(11) **EP 4 765 028 A1**

(12) **EUROPÄISCHE PATENTANMELDUNG**

(43) Veröffentlichungstag:
**24.06.2026  Patentblatt 2026/26**

(21) Anmeldenummer: **25153316.2**

(22) Anmeldetag: **22.01.2025**

(51) Internationale Patentklassifikation (IPC):
**G06T 15/50** (2011.01)    **G05B 19/418** (2006.01)
**G02B 27/00** (2006.01)

(52) Gemeinsame Patentklassifikation (CPC):
**G06T 15/506; G02B 27/0012; G06T 15/06;
H04N 9/73; H04N 17/002**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(30) Priorität: **20.12.2024  DE 102024139225**

(71) Anmelder: **dSPACE SE & Co. KG
33102 Paderborn (DE)**

(72) Erfinder:
• **Hante, Stefan
  33102 Paderborn (DE)**
• **Brodehl, Christoph
  33102 Paderborn (DE)**

(54) **HERLEITUNG EINES ELEKTROMAGNETISCHEN SPEKTRUMS AUS EINEM MULTISTIMULUS-FARBWERT ZUR SIMULATION EINER KAMERA**

(57)    Beim Rendering einer Abbildung einer virtuellen Szenerie werden Farbinformationen zumindest eines Flächenelements der virtuellen Szenerie in Form von Farbraumkoordinaten eines Multistimulus-Farbraums hinterlegt. Dem Flächenelement wird eine Anzahl von Basisfunktionen zugeordnet, die jeweils eine relative Wellenlängenverteilung eines von dem Flächenelement ausgestrahlten Lichtanteils beschreiben, und eine spektrale Strahldichte wird als Linearkombination der Basisfunktionen modelliert. Durch eine Verrechnung der spektralen Strahldichte mit zumindest einer Farbraumkoordinate aus der Farbinformation des Flächenelements und zumindest einer der Farbraumkoordinate zugeordneten Farbabgleichsfunktion werden die Skalierungsfaktoren der Basisfunktionen hergeleitet und durch Einsetzen der Skalierungsfaktoren die spektrale Strahldichte berechnet. Durch Verarbeitung der spektralen Strahldichte in einer Kamerasimulation einer in der virtuellen Szenerie angeordneten Kamera werden synthetischen Kameradaten berechnet.

Fig. 1

**Beschreibung**

Kameras finden zunehmend Anwendung in intelligenten automatisierten Systemen, die sich anhand eines Kamerabildes ein detailliertes Bild ihrer Umgebung herleiten und eigenständig auf Ereignisse in der Umgebung reagieren können. Derartige Systeme können beispielsweise hochautomatisierte bis autonome Fahrzeuge bzw. Roboter sein, die sich eigenständig und sicher in einer unbekannten Umgebung fortbewegen können. Ein weiteres Beispiel sind Überwachungssysteme, die in einem Kamerabild eigenständig gefährliche oder unerwünschte Situationen erkennen und Alarm geben können.

Derartige kamerabasierte Systeme übernehmen oft sicherheitskritische Aufgaben und bedürfen vor ihrer Serienfertigung einer gründlichen Evaluierung. Die Evaluierung in einer realen Umgebung ist meistens zeitaufwendig, weil kritische Ereignisse naturgemäß selten auftreten und dann auch nicht reproduzierbar sind. Deswegen ist es üblich, Testläufe des Systems zumindest teilweise in einer virtuellen Umgebung durchzuführen, in der die Kameradaten auf Basis der virtuellen Umgebung synthetisch erzeugt und dem unter Test stehenden System bereitgestellt werden.

Wenn das kamerabasierte System auf einer trainierten künstlichen Intelligenz (KI) beruht, beispielsweise einer KI zur Objekterkennung, Gesichtserkennung oder Szeneninterpretation, besteht für das Training der KI ein analoges Problem. Bestimmte Trainingssituationen sind unter Umständen selten und nicht reproduzierbar. Deshalb gibt es vermehrt Bestrebungen, KIs in virtuellen Umgebungen mittels synthetischer Kameradaten zu trainieren.

Sowohl für die Evaluierung als auch für das Training kamerabasierter Systeme ist es wichtig, dass die synthetischen Kameradaten glaubhaft sind, also eine möglichst hohe Ähnlichkeit mit echten Kameradaten aufweisen, damit die anhand der synthetischen Kameradaten in der virtuellen Umgebung erzielten Ergebnisse auf die echte Welt übertragbar sind. Dafür ist es unter Umständen nötig, die technisch-physikalischen Prozesse in der Kamera, die zur Erzeugung der Kameradaten in einer realen Kamera durchlaufen werden, realitätsnah zu simulieren, insbesondere dann, wenn die synthetischen Kameradaten vorgesehen sind, Kameradaten zu imitieren, deren Verarbeitungsgrad niedrig ist, z.B. die vom Bildsensor erzeugten Kamerarohdaten.

Das von der realen Umwelt ausgestrahlte, einen realen Kamera-Bildsensor belichtende Licht ist spektral. Es setzt sich aus einem kontinuierlichen Spektrum unterschiedlicher Wellenlängen zusammen. Typische Grafikengines zum Rendering virtueller Umgebungen (z.B. Unreal Engine, Unity Engine, CryEngine) stellen Farbe als Mischungen weniger diskreter Farbwerte dar, typischerweise anhand eines RGB-Farbraums. Das sind Tristimulus-Farbräume, die jeden Farbton als eine Mischung von drei diskreten Farbanteilen, Rot, Grün und Blau, darstellen. Diese Darstellung ermöglicht zwar einen realistischen Farbeindruck im menschlichen Auge, entspricht aber nicht der physikalischen Realität. Eine mit RGB-Farbwerten bespeiste Kamerasimulation erzeugt keine der Realität entsprechenden Kamerarohdaten, selbst unter der Annahme einer perfekten Simulation des Bildsensors und der Abbildungsoptik.

Zur computerimplementierten Simulation wellenoptischer Phänomene, insbesondere auch der Belichtung und Bilddatenerzeugung einer digitalen Kamera, ist im Stand der Technik das sogenannte spektrale Rendering bekannt. Dabei wird Farbe von vornherein nicht als diskreter Multistimulus-Farbwert modelliert, sondern als Spektrum. Beispiele sind der Fachaufsatz "Digital Camera Simulation" von Joyce Farrel, Peter Catrysse und Bran Wandell (Applied Optics 51(4), 2012) und die Patentveröffentlichung US 5 710 876 A. Der Rechenaufwand dafür ist aber erfahrungsgemäß so hoch, dass eine in Realzeit ablaufende Kamerasimulation in hinreichender Qualität nicht möglich ist.

Zur Verringerung des Rechenaufwandes ist es bekannt, aus einem gegebenen RGB-Wert ein Spektrum abzuschätzen und auf diese Weise eine schon nativ vorhandene RGB-Pipeline für eine spektrale Lichtsimulation zu nutzen. Ein solcher Ansatz ist beispielsweise in dem Fachaufsatz "GPU Rendering of the Thin Film on Paints with Full Spectrum" von Roman Ďurikovič und Ryou Kimura (Tenth International Conference on Information Visualisation, 2006) offenbart. Der Aufsatz schlägt vor, die gegebenen RGB-Werte durch eine Linearkombination dreier vorgegebener Spektren zu ersetzen, die im menschlichen Auge die Farbeindrücke Rot, Grün bzw. Blau erzeugen. Diese Methode ist zwar schnell durchführbar, ist aber eine eher grobe Näherung und ungeeignet für die Simulation von Infrarotkameras oder Ultraviolettkameras, die außerhalb des sichtbaren Spektrums arbeiten.

Dem Fachmann ebenfalls bekannt sind Verfahren zur Berechnung synthetischer Kameradaten unterschiedlicher Ausgestaltung auf Basis einer Kamerasimulation und einer virtuellen Szenerie. Eine Einführung findet sich beispielsweise in der Druckschrift "Full Spectrum Camera Simulation for Reliable Virtual Development and Validation of ADAS and Automated Driving Application" von René Molenaar et al. (IEEE Intelligent Vehicles Symposium (IV), 2015).

Vor diesem Hintergrund ist es die Aufgabe der Erfindung, die schnelle Abschätzung eines Spektrums aus einem vorgegebenen Multistimulus-Farbwert zu verbessern.

Die Erfindung ist ein computerimplementiertes Verfahren zur Erzeugung synthetischer Kameradaten. Das Verfahren umfasst ein Rendering einer Abbildung einer virtuellen Szenerie und eine Hinterlegung von Farbinformationen zumindest eines Flächenelements der virtuellen Szenerie in Form von Farbraumkoordinaten eines Multistimulus-Farbraums. Ein Flächenelement kann beispielsweise ein Polygon, ein Surfel, eine Textur, ein Pixel oder eine Seitenfläche eines Voxels sein. Unter einem Multistimulus-Farbraum ist ein Farbraum zu verstehen, der Farben als N-dimensionale Vektoren bzw. Wertetupel modelliert, wobei jede Vektorkoordinate einen diskreten, vorgegebenen Farbwert repräsentiert.

Computergrafik, insbesondere von gängigen Grafik-Engines, basiert meistens auf einem dreidimensionalen RGB-Farbraum, zum Beispiel dem sRGB-Farbraum.

Das von dem Flächenelement ausgestrahlte Licht wird zunächst gemäß der Formel

$$L(\lambda) = c_1 B_1(\lambda) + \ldots + c_m B_m(\lambda) \qquad (1)$$

als eine Linearkombination einer Anzahl von m Basisfunktionen B modelliert. L ist eine spektrale Strahldichte des Flächenelements, und jede Basisfunktion ist eine relative Wellenlängenverteilung eines von dem Flächenelement ausgestrahlten Lichtanteils. Die spektrale Strahldichte wird also beschrieben als eine Überlagerung von m elektromagnetischen Spektren mit noch zu bestimmenden Skalierungsfaktoren $c_1, \ldots, c_m$.

Die Herleitung der Skalierungsfaktoren der Linearkombination geschieht durch eine Verrechnung der spektralen Strahldichte mit zumindest einer Farbraumkoordinate aus der Farbinformation des Flächenelements und zumindest einer der Farbraumkoordinate zugeordneten Farbabgleichsfunktion. Dafür kann für jede Farbraumkoordinate die folgende Formel verwendet werden:

$$k_i = R_i \int_{\lambda_1}^{\lambda_2} L(\lambda) \overline{k}_i(\lambda) \mathrm{d}\lambda \qquad (2)$$

$k_i$ ist eine Koordinate des Farbraumvektors $k = (k_1, k_2, \ldots, k_n)$. Im sRGB-Farbraum ist zum Beispiel $k = (r, g, b)$. Der Vektor $\overline{k} = (\overline{k}_1, \overline{k}_2, \ldots, \overline{k}_n)$ beinhaltet die den Farbraumkoordinaten zugeordneten Farbabgleichsfunktionen. Im sRGB-Farbraum sind $\overline{k} = (\overline{r}, \overline{g}, \overline{b})$ lineare Transformationen der CIE-1931-RGB-Farbabgleichsfunktionen. $R_i = (R_1, R_2, \ldots, R_n)$ sind farbraumspezifische Konstanten. Die Formel (2) dient eigentlich dazu, einem gegebenen elektromagnetischen Spektrum, beschrieben durch die spektrale Strahldichte L, einen Satz von Farbraumkoordinaten $k$ zuzuordnen, die dem menschlichen Auge denselben Farbeindruck vermitteln wie das gegebene Spektrum. Im Verfahren gemäß Erfindung sind die Farbraumkoordinaten des Flächenelements bereits bekannt. Einsetzen der Gleichung (1) in die Gleichung (2) ergibt das Gleichungssystem

$$k_1 = c_1 R_1 \int_{\lambda_1}^{\lambda_2} B_1(\lambda) \, \overline{k}_1 \mathrm{d}\lambda \; + \ldots + c_m R_1 \int_{\lambda_1}^{\lambda_2} B_m(\lambda) \, \overline{k}_1(\lambda) \mathrm{d}\lambda$$

$$\vdots \qquad\qquad\qquad\qquad\qquad\qquad\qquad\qquad (3)$$

$$k_n = c_1 R_n \int_{\lambda_1}^{\lambda_2} B_1(\lambda) \overline{k}_n(\lambda) \mathrm{d}\lambda + \ldots + c_m R_n \int_{\lambda_1}^{\lambda_2} B_m(\lambda) \overline{k}_n(\lambda) \mathrm{d}\lambda$$

zur Bestimmung der Skalierungsfaktoren $c_1, \ldots, c_m$. Einsetzen der Skalierungsfaktoren $c_1, \ldots, c_m$ in die Gleichung (1) ergibt die spektrale Strahldichte des Flächenelements.

Durch Verarbeitung der spektralen Strahldichte in einer dafür ausgestalteten Kamerasimulation einer in der virtuellen Szenerie angeordneten Kamera werden die synthetischen Kameradaten berechnet.

Das Verfahren verrechnet zur Herleitung eines elektromagnetischen Spektrums eine physikalisch plausible Vorannahme über das Strahlungsspektrum eines Flächenelements (Gleichung 1) mit den aus der virtuellen Szenerie bereits vorgegebenen Multistimulus-Farbwerten des Flächenelements. Das auf diese Weise hergeleitete Spektrum ist realitätsnäher als bei den im Stand der Technik bekannten Verfahren und erzeugt dadurch qualitativ bessere synthetische Kameradaten, aber es ist auch hinreichend schnell durchführbar für eine Kamerasimulation in Realzeit. Eine solche ist notwendig, wenn die synthetischen Kameradaten zur Stimulation eines Prüflings vorgesehen sind, der als eigenständige Hardware ausgestaltet ist, die sich außerhalb des zur erfindungsgemäßen Erzeugung der synthetischen Kameradaten verwendeten Computersystems befindet ("Hardware in the Loop"). Ein solcher Prüfling erwartet innerhalb vorgegebener Zeitintervalle aktuelle Kameradaten, die das Verfahren dementsprechend innerhalb derselben Zeitintervalle berechnen und bereitstellen muss. Der dafür notwendige wiederholte Durchlauf der Verfahrensschritte ist dann vorteilhaft an eine Szenensimulation gebunden, die eine zeitliche Entwicklung der virtuellen Szenerie simuliert, z.B. eine Fortbewegung von Verkehrsteilnehmern in einer Straßenverkehrsszenerie. Die Abbildung der Szenerie, und in der Folge auch die synthetischen Kameradaten, bildet dann in jedem Durchlauf einen momentanen Zustand der virtuellen Szenerie ab, wobei der momentane Zustand insbesondere momentane Orte, räumliche Ausrichtungen oder Haltungen von Objekten in der virtuellen Szenerie umfasst.

Den größten Rechenaufwand zur Herleitung der Skalierungsfaktoren gemäß der Gleichung (3) erfordert die Lösung der Integrale. Da diese aber weder orts- noch zeitabhängig sind, reicht es aus, sie einmalig zu berechnen. Für jedes Flächenelement, dem eine oder mehrere Basisfunktionen zugeordnet sind, können die zur Herleitung der Skalierungsfaktoren zu lösenden Integrale vorberechnet werden und nach Abschluss der Vorberechnung die Szenensimulation gestartet werden. Der nach Lösung der Integrale in der Gleichung (3) noch aufzubringende Rechenaufwand zur Ermittlung der Skalierungsfaktoren $c_1,...,c_m$ ist so gering, dass er problemlos in Realzeit durchführbar ist.

Wenn das Flächenelement als passiver Strahler ausgestaltet ist, ist es vorteilhaft, dass zumindest die erste Basisfunktion $B_1$ (ohne Beschränkung der Allgemeinheit) einen spektralen Verlauf einer Ausleuchtung des Flächenelements und ein Reflexionsspektrum des Flächenelements berücksichtigt. Der spektrale Verlauf der Ausleuchtung kann optional als Normlichtart ausgestaltet sein, beispielsweise Normlichtart A (Glühlampe), D65 (StandardTageslicht), F1 bis F6 (Leuchtstoffröhre, unterschiedliche Typen) und LED-RGB1 (weißes LED-Licht). Das Reflexionsspektrum kann insbesondere einem Materialattribut zugeordnet sein, das wiederum dem Flächenelement zugeordnet ist bzw. zuordbar ist. Ein Softwarewerkzeug zur Erstellung der virtuellen Szenerie kann beispielsweise eine Materialdatenbank mit einer Vielzahl unterschiedlicher Materialattribute umfassen, die sich unterschiedlichen Flächenelementen in der virtuellen Szenerie zuordnen lassen. Jedem Materialattribut in der Datenbank ist ein materialspezifisches Reflexionsspektrum zugeordnet, und das jeweils zugeordnete Reflexionsspektrum wird durch die Zuordnung eines Materialattributs an ein Flächenelement automatisch dem Flächenelement zugeordnet.

Die Farbraumkoordinaten $k_1,..., k_n$ werden vorzugsweise unter Berücksichtigung einer räumlichen Ausrichtung des Flächenelements in Relation zu der simulierten Kamera berechnet, also unter Berücksichtigung eines Winkels zwischen einer optischen Achse der Kamera und einer Flächennormalen des Flächenelements. Eine derartige Winkelabhängigkeit ist in der Fachwelt als Bidirektionale Reflexionsverteilungsfunktion bekannt. Ihre Berücksichtigung bei der Berechnung von Farbraumkoordinaten eines Flächenelements ist in vielen Grafikengines nativ eingebaut. Die Verwendung winkelabhängiger Farbraumkoordinaten im Rahmen des erfindungsgemäßen Verfahrens ergibt eine winkelabhängige spektrale Simulation, die im Stand der Technik nur mit hohem Rechenaufwand und nicht in Realzeit durchführbar ist.

Das Verfahren ist auch geeignet für die Simulation von Infrarotkameras oder Ultraviolettkameras, die vollständig oder teilweise außerhalb des sichtbaren Spektralbereichs arbeiten, also unterhalb von 380 Nanometern oder oberhalb von 780 Nanometern. Die spektrale Strahldichte wird dafür so berechnet, dass sie die gewünschten Wellenlängen außerhalb des sichtbaren Spektralbereichs umfasst, beispielsweise durch entsprechende Auswahl der Integrationsgrenzen $\lambda_1$, $\lambda_2$ in der Gleichung (3).

Die anhand des Verfahrens berechneten Kameradaten sind bevorzugt als Kamerarohdaten ausgestaltet. Darunter sind die unverarbeiteten Daten zu verstehen, die von dem Bildsensor der Kamera unmittelbar ausgegeben werden. Im Normalfall handelt es sich bei den Kamerarohdaten um eine Matrix von elektrischen Größen (elektrische Spannung, Stromstärke oder Ladung), von denen jede eine Belichtung eines Bildsensorpixels widerspiegelt. Die elektrische Antwort eines einzelnen Bildsensorpixels ergibt sich aus dem Spektrum des den Pixel belichtenden Lichts und der Quanteneffizienz des Pixels. Die Quanteneffizienz ist eine wellenlängenabhängige Empfindlichkeit des Pixels. Unter Berücksichtigung zumindest einer Quanteneffizienz eines simulierten Bildsensors der simulierten Kamera, z.B. einer einheitlich für alle simulierten Sensorpixel geltenden Quanteneffizienz, lassen sich deshalb aus der berechneten Spektraldichte, bzw. aus einer Mehrzahl anhand des erfindungsgemäßen Verfahrens berechneter Spektraldichten, unmittelbar Kamerarohdaten berechnen.

Die synthetischen Kameradaten werden vorzugsweise durch zumindest eine Komponente eines zur Verarbeitung der Kameradaten ausgestalteten elektronischen Systems eingelesen und verarbeitet. Eine Schnittstelle zur Bereitstellung der Kameradaten, sodass die zumindest eine Komponente sie einlesen kann, ist in diesem Fall bereitzustellen. Die Komponente oder das elektronische System können ein Prüfling sein, dessen Reaktion auf die Kameradaten zu evaluieren ist. Statt zur Evaluierung können die synthetischen Kameradaten auch zum Training des elektronischen Systems, insbesondere eines neuronalen Netzes des elektronischen Systems, vorgesehen sein. Das elektronische System kann insbesondere ein elektronisches System in Entwicklung sein. Die Komponente kann das vollständige elektronische System umfassen oder eine beliebige Substruktur des elektronischen Systems, beispielsweise ein Teilsystem, eine Baugruppe, eine elektronische Komponente, ein Bauteil, einen einzelnen Prozessor, ein einzelnes FPGA (Field Programmable Gate Array) bzw. ein vergleichbares Bauteil zur Implementierung einer hartverdrahteten Programmlogik, eine Software oder eine Softwarekomponente.

Aufgrund seiner Eignung zur Simulation von Infrarotkameras ist das Verfahren besonders geeignet zur Evaluierung oder zum Training eines Assistenzsystems, das vorgesehen ist, zur Überwachung eines Zustands einer Person Kameradaten von einer Kamera auszuwerten, die auf die Person gerichtet ist. Die Person kann insbesondere eine ein Fahrzeug oder eine Maschine bedienende Person sein. Derartige Assistenzsysteme arbeiten häufig in infraroten Bereich. Dadurch funktionieren sie auch bei Dunkelheit, bzw. es ist möglich, die Person mit infrarotem Licht auszuleuchten, ohne sie zu blenden. Die virtuelle Szenerie umfasst in diesem Fall eine virtuelle Repräsentation der Person, und die Abbildung der virtuellen Szenerie dementsprechend eine Abbildung der Person. Der spektrale Verlauf der Ausleuchtung kann dementsprechend eine infrarote (oder unter Umständen auch ultraviolette) Ausleuchtung der bedienenden Person nachbilden.

Die Erfindung bezieht sich auch auf ein Computerprogrammprodukt, das Mittel zur Durchführung eines erfindungsgemäßen Verfahrens umfasst. Die Erfindung bezieht sich auch auf ein Computersystem, das Mittel zur Berechnung synthetischer Kameradaten gemäß dem erfindungsgemäßen Verfahren umfasst, und weiterhin eine Schnittstelle zur Bereitstellung der synthetischen Kameradaten zur Einlesung und Verarbeitung durch zumindest eine Komponente eines zur Verarbeitung der Kameradaten ausgestalteten elektronischen Systems.

Die Zeichnungen und deren nachfolgende Beschreibung stellen ein Ausführungsbeispiel der Erfindung vor. Es zeigen

Figur 1     eine Datenpipeline zur Erzeugung der Kameradaten;

Figur 2     die winkelabhängige Erzeugung von Multistimulus-Bilddaten; und

Figur 3     ein beispielhaftes virtuelles Szenario;

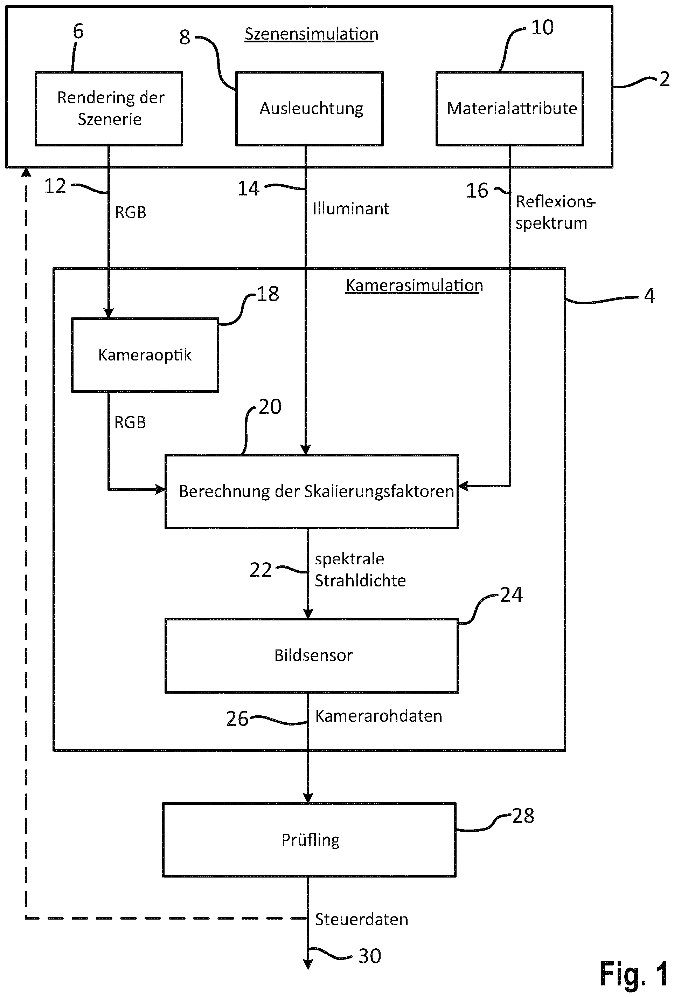

Wie in der Abbildung der Figur 1 gezeigt, umfasst ein Computersystem zur Ausführung der Erfindung typischerweise drei Komponenten: Eine Szenensimulation 2, eine Kamerasimulation 4 und einen Prüfling 28.

Die Szenensimulation umfasst ein Rendering 6 der Szenerie 42. Für das Rendering 6 wird eine Grafikengine genutzt, wie sie von unterschiedlichen Anbietern auf dem Markt erhältlich ist, beispielhaft die Unreal Engine von Epic Games, Inc. Die Szenerie 42 ist eine 3D-Szenerie, die mit einer Vielzahl statischer und beweglicher Grafikobjekte angefüllt ist. Die Ausgestaltung der Szenerie 42 ist vom Prüfling 28 und den Testanforderungen abhängig. Grundsätzlich sollten die für die vorgesehene Nutzung des Prüflings 28 wesentlichen Aspekte, zu deren Erkennung und Bewertung der Prüfling vorgesehen ist, in der Szenerie 42 enthalten sein. Ist der Prüfling 28 beispielsweise als Teil einer Fußgängererkennung eines hochautomatisierten Automobils vorgesehen, dann sollte die Szenerie 42 als eine Straßenverkehrsszenerie ausgestaltet sein, die virtuelle Fußgänger umfasst. Ist der Prüfling 28 eine virtuelle Überwachungskamera zur automatischen Erkennung von Ertrinkungsunfällen, dann sollte die Szenerie 42 ein Gewässer mit virtuellen Schwimmern darstellen, von denen einige typisches Verhalten eines in Not geratenen Schwimmers darstellen.

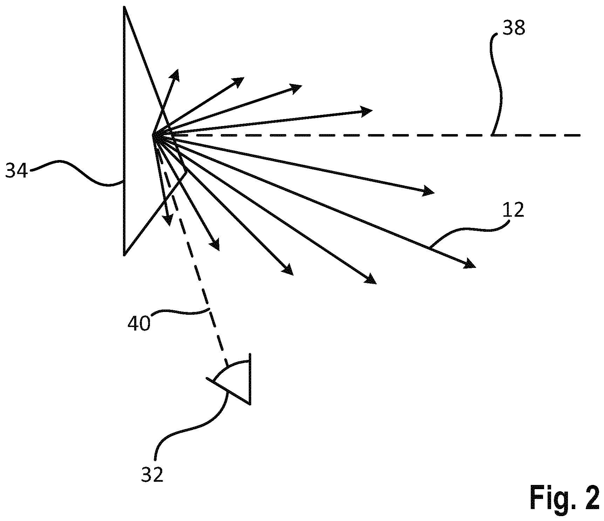

Die Abbildung der Figur 2 verdeutlicht den Verfahrensschritt des Renderings 6. Die Grafikengine rendert die Szenerie 42 anhand eines sRGB-Farbraums, der für eine für das menschliche Auge realistisch erscheinende Darstellung der Szenerie 42 auf einem Monitor optimiert ist. Die Szenerie 42 setzt sich aus einer Vielzahl von texturierten Polygonen 34 zusammen, die die elementaren Flächenelemente der in der Szenerie 42 sichtbaren Oberflächen ausbilden. Die Grafikengine rendert die Szenerie 42 aus der Perspektive einer virtuellen Kamera 32 und hinterlegt für das Rendering 6 für jedes von der virtuellen Kamera 32 sichtbare Flächenelement 34 eine Farbinformation in Form eines RGB-Vektors 12. Ein RGB-Vektor 12 umfasst drei Farbraumkoordinaten für die Farbwerte Rot, Grün und Blau. Die Werte der drei Koordinaten sind aber abhängig von der räumlichen Ausrichtung des Flächenelements 34 in Relation zur virtuellen Kamera 32, d.h. von einem Raumwinkel zwischen der Verbindungsgeraden 40 der virtuellen Kamera 32 zu dem Flächenelement 34 und der Flächennormalen 38 des Flächenelements 34. Dazu kommt, bei einem reflektierenden Flächenelement 34, eine Abhängigkeit von der Position der Lichtquelle. In der Zeichnung ist diese Abhängigkeit durch unterschiedliche Beträge der RGB-Vektoren 12 in unterschiedliche Raumrichtungen dargestellt. Auf diese Weise simuliert die Grafikengine eine Richtungsabhängigkeit der von dem Flächenelement 34 ausgehenden elektromagnetischen Strahlung.

Zurück zu Figur 1. Die Szenensimulation 2 umfasst weiterhin eine Ausleuchtung 8 und Materialattribute 10. Bei beiden handelt es sich um zusätzliche Information, welche die von der Grafikengine gerenderte Szenerie 42 ergänzt, aber von der Grafikengine nativ nicht bereitgestellt wird. Die Ausleuchtung 8 umfasst mindestens einen Illuminanten 14, d.h. ein elektromagnetisches Spektrum eines das Flächenelement 34 ausleuchtenden Umgebungslichtes. Die Ausleuchtung 8 kann mehrere elektromagnetische Spektren umfassen, wenn das Flächenelement 34 in der Szenerie 42 von mehreren unterschiedlich gearteten Lichtquellen 46 ausgeleuchtet wird. Jedes in der Ausleuchtung 8 hinterlegte elektromagnetische Spektrum kann als analytischer Ausdruck oder als Nachschlagetabelle hinterlegt sein, wobei eine Hinterlegung als eine hinreichend fein aufgelöste Nachschlagetabelle vorteilhaft ist.

Die Materialattribute 10 sind eine Materialdatenbank mit einer Vielzahl von Materialien, und jedes Material ist einem gegebenen Flächenelement 34 als Attribut zuordbar. Einer Vielzahl von Materialattributen 10 ist jeweils ein Reflexionsspektrum S (Bezugszeichen 16) zugeordnet und in der Materialdatenbank hinterlegt. Ein Reflexionsspektrum 16 ist ein materialspezifisches, wellenlängenabhängiges Reflexionsvermögen, das für ein Spektrum von Wellenlängen angibt, welcher Anteil einer einfallenden Lichtintensität der jeweiligen Wellenlänge von dem Material reflektiert wird.

Unter der beispielhaften Annahme, das Flächenelement 34 sei ein Teil des Gesichts eines von der Grafikengine gerenderten Autofahrers 44, dann kann dem Flächenelement 34, je nach gewünschter Hautfarbe des Autofahrers 44, zum Beispiel ein Materialattribut "menschliche Haut (mittelhell)" zugeordnet sein, und infolge dieser Zuordnung ein Reflexionsspektrum 16, das das in der Realität gemessene Reflexionsspektrum menschlicher Haut der entsprechenden Hautfarbe nachbildet. Die den Materialattributen 10 zugeordneten Reflexionsspektren 16 sind ausschließlich wellenlängenabhängig. Sie berücksichtigen keine Winkelabhängigkeit der Reflexion.

Die Kamerasimulation 4 ist ebenfalls kein nativer Bestandteil der Grafikengine, sondern ergänzt diese. Sie ist nicht zu verwechseln mit der virtuellen Kamera 32. Letztere bestimmt lediglich das von der Grafikengine gerenderte Bild, während die Kamerasimulation 4 die Datenpipeline einer realen Kamera emuliert. Die von der Kamerasimulation 4 simulierte Kamera ist allerdings hinsichtlich ihrer Position und räumlichen Ausrichtung in der virtuellen Szenerie 42 identisch mit der virtuellen Kamera 32, sodass das Rendering 6 der Grafikengine von der Kamerasimulation 4 zur Weiterverarbeitung nutzbar ist. Beide können sich auch prozesstechnisch überlappen, sodass native Algorithmen der virtuellen Kamera 32 unmittelbar für die Kamerasimulation 4 genutzt werden, bzw. dass Algorithmen der Kamerasimulation 4 in native Algorithmen der virtuellen Kamera 32 integriert sind. Das wesentliche Unterscheidungsmerkmal ist, dass die virtuelle Kamera 32 der Grafikengine eine auf einem Monitor darstellbare RGB-Abbildung (allgemeiner: eine Multistimulus-Abbildung) der virtuellen Szenerie 42 aus Perspektive der virtuellen Kamera 32 rendert, während die Kamerasimulation 4 Kameradaten auf Basis der virtuellen Szenerie aus derselben Perspektive generiert.

Die Kamerasimulation 4 liest die von der Grafikengine hinterlegten, den Flächenelementen 34 zugeordneten RGB-Vektoren 12 mit den Farbraumkoordinaten ein und verarbeitet sie in einer Kameraoptiksimulation 18. Die Kameraoptiksimulation 18 simuliert den Prozess der Abbildung des aus der virtuellen Szenerie in die Kamera einfallenden Lichts auf die Sensorpixel eines Bildsensors der simulierten Kamera. Als Ergebnis der Kameraoptiksimulation 18 liegt für jeden simulierten Sensorpixel ein RGB-Vektor 12 für das den jeweiligen Sensorpixel belichtende Licht vor. Aus jedem dieser RGB-Vektoren 12 wird nachfolgend unter Anwendung von Gleichung (3) ein elektromagnetisches Spektrum berechnet.

Eine Berechnungsroutine 20 für die Skalierungsfaktoren $c_1,...,c_m$, die für jeden Sensorpixel ausgeführt wird, liest den RGB-Vektor 12 des jeweiligen Sensorpixels von der Kameraoptiksimulation 18 ein. Die Berechnungsroutine 20 liest von der Ausleuchtung 8 einen oder mehrere Illuminanten des Flächenelements 34 ein, das auf den jeweiligen Sensorpixel abgebildet ist. Die Berechnungsroutine 20 liest aus den Materialattributen 10 das dem Flächenelement 34, das auf den jeweiligen Sensorpixel abgebildet ist, zugeordnete Reflexionsspektrum 16 aus.

Der Prüfling 28 wird für das hier beschriebene Ausführungsbeispiel als ein Fahrassistenzsystem zur Überwachung eines Autofahrers 44 angenommen. Das Fahrassistenzsystem ist vorgesehen, anhand messbarer Kriterien, z.B. Blickrichtung, Kopfhaltung, Gähnen oder Häufigkeit des Augenzwinkerns, die Aufmerksamkeit und Fahrtüchtigkeit des Fahrers zu überwachen und bei Bedarf Steuerdaten für eine Peripherie des Assistenzsystems 28 auszugeben, um eine Reaktion des Fahrzeugs einzuleiten, z.B. ein Wecksignal, eine Aufforderung zur Rast, einen Notruf, einen Wechsel in einen autonomen Fahrmodus oder ein Notbremsmanöver.

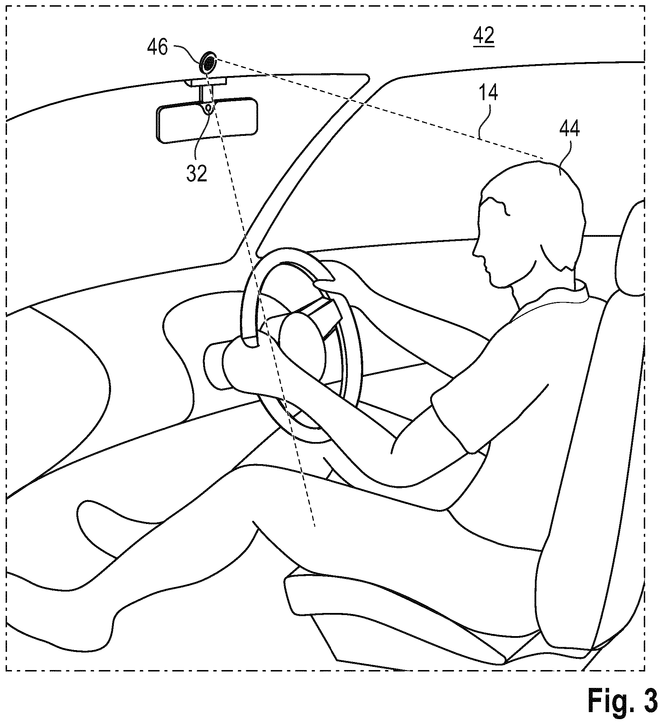

Die Abbildung der Figur 3 skizziert eine für einen Test oder ein Training dieses Assistenzsystems eingerichtete virtuelle Szenerie 42. Die virtuelle Szenerie 42 umfasst einen Innenraum eines Fahrzeugs mit einem Fahrer 44. Die Szenerie macht eine zeitliche Entwicklung durch: Das Grafikmodell des Fahrers 44 bewegt sich und kann insbesondere für den Prüfling 28 relevante Verhaltensweisen realitätsgetreu nachbilden, z.B. Gähnen, Abwenden der Augen von der Fahrbahn, Sekundenschlaf, Drogen- oder Alkoholeinfluss oder medizinische Notfälle wie einen Herzinfarkt, einen Schlaganfall oder einen Schock. Die virtuelle Kamera 32 ist an der Vorderseite des Innenspiegels positioniert und simuliert eine auf den Fahrer 44 gerichtete Innenraumkamera zur Überwachung des Fahrers 44. Die simulierte Innenraumkamera erfasst ein elektromagnetisches Spektrum des Wellenlängenbereichs $\lambda$ = [650 nm, 1100 nm], arbeitet also teilweise im nahinfraroten Bereich.

Die virtuelle Szenerie 42 umfasst auch eine Infrarotlampe 46 zur für das menschliche Auge unsichtbaren Ausleuchtung 14 des Fahrers 44. Das elektromagnetische Spektrum der Infrarotlampe ist in der Ausleuchtung 8 als erster Illuminant $I_{IR}$ hinterlegt. Das von außen in das Fahrzeug eindringende Tageslicht ist in der Ausleuchtung 8 als zweiter Illuminant $I_D$ = D65 (Standardtageslicht nach dem CIE-Normvalenzsystem) hinterlegt.

Dem Flächenelement 34 ist gemäß den Materialattributen 10 ein Reflexionsspektrum $S_{H1}$ (menschliche Haut, mittelhell) zugeordnet. Die Berechnungsroutine 20 in der Figur 1 weist dem Flächenelement 34 unter Verwendung der ausgelesenen Informationen eine einzige Basisfunktion gemäß Gleichung (1) zu:

$$B_1 = (wI_{IR} + I_D)S_{H1}$$

mit einem Gewichtungsfaktor w zur Festlegung der relativen Intensität der infraroten Ausleuchtung im Vergleich zum Tageslicht. Die Basisfunktion $B_1$ beschreibt ein winkelunabhängiges, vom Flächenelement 34 reflektiertes elektromagnetisches Spektrum. Für diese Basisfunktion führt die Berechnungsroutine 20 die folgenden Berechnungen durch: Die spektrale Strahldichte des von dem Flächenelement 34 auf einen Bildsensorpixel abgebildeten Lichts ergibt sich nach Gleichung (1) zu

$$L(\lambda) = c_1(wI_{IR} + I_D)S_{H1}$$

und der Koeffizient $c_1$ ergibt sich gemäß Gleichung (3) durch

$$r = c_1 R_1 \int_{\lambda_1 = 650\,\text{nm}}^{\lambda_2 = 1100\,\text{nm}} \left(w I_{IR}(\lambda) + I_D(\lambda)\right) S_{H1}(\lambda) \bar{r}\, d\lambda$$

Alle in dem Integral auftretenden Größen sind bereits vor dem Start der Szenensimulation 2 bekannt, und die Anzahl der von der Berechnungsroutine 20 potenziell zu verarbeitenden Basisfunktionen ist endlich, sofern die Anzahlen der in den Materialattributen 10 hinterlegten Reflexionsspektren 16 und der in der Ausleuchtung 8 hinterlegten Illuminanten 14 endlich ist. Folglich können alle von der Berechnungsroutine 20 potenziell zu verrechnenden Integrale, d.h. die Integrale, die sich durch alle möglichen Kombinationen von Illuminanten und Reflexionsspektren ergeben, schon vor dem Start der Szenensimulation 2 vorabberechnet und zur Auslesung durch die Berechnungsroutine 20 in einem Speicher hinterlegt werden. Die Berechnung der spektralen Strahldichte 22 durch Ermittlung von $c_1$ ist dann problemlos ist Realzeit durchführbar. Die Farbraumkoordinate r ist im RGB-Vektor 12 hinterlegt und von der Grafikengine winkelabhängig zugeliefert. Dadurch ist auch $c_1$ und letztlich die spektrale Strahldichte $L(\lambda)$ winkelabhängig. Das Verfahren ermöglicht also unter Ausnutzung der in der Grafiengine nativ vorhandenen RGB-Pipeline eine realzeitfähige, winkelabhängige spektrale Kamerasimulation. Dem Flächenelement können optional noch weitere Basisfunktionen zugeordnet werden, beispielsweise als Korrekturterm oder zur Berücksichtigung eines von dem Flächenelement 34 aktiv ausgestrahlten Strahlungsspektrums, wenn das Flächenelement 34 innerhalb der virtuellen Szenerie 42 zu einem aktiven Strahler gehört.

Die Berechnung kann optional für die beiden übrigen Farbraumkoordinaten $g$ und $b$ wiederholt werden. Auf diese Weise erhält man drei unabhängige Werte für $c_1$, die, da unabhängig voneinander berechnet, wahrscheinlich geringfügig voneinander abweichen werden, und kann dadurch Fehlerminimierung betreiben. Beispielsweise kann man aus dem erhaltenen Werteintervall für $c_1$ den Wert auswählen, für den der anhand des Wertes berechnete Vektor $(r, g, b)$ die kleinste Abweichung von dem von der Grafikengine zugelieferten Vektor aufweist.

Die spektrale Strahldichte $L$ (Bezugszeichen 22) wird von einer Bildsensorsimulation 24 eingelesen, die unter Verwendung der für einen gegebenen Sensorpixel errechneten spektralen Strahldichte $L$ und einer wellenlängenabhängigen Quanteneffizienz $q$ des Sensorpixel die elektrische Antwort des Sensorpixels berechnet und, als Gesamtheit der elektrischen Antworten aller Sensorpixel, die Kamerarohdaten 26. Im einfachsten Fall ergibt sich die elektrische Antwort $R_E$ eines Sensorpixels durch die Gleichung

$$R_E = K \int_{\lambda_1}^{\lambda_2} L(\lambda) q(\lambda) d\lambda = K c_1 \int_{\lambda_1}^{\lambda_2} \left(w I_{IR}(\lambda) + I_D(\lambda)\right) S_{H1}(\lambda) q(\lambda) d\lambda$$

Auch dieses Integral hängt allein von der Wellenlänge ab und wird deshalb analog zu den Integralen in Gleichung (3) vor Beginn der Szenensimulation vorabberechnet und zur Einlesung durch die Bildsensorsimulation 24 in einem Speicher hinterlegt. $K$ ist ein veränderlicher Skalierungsfaktor, der insbesondere der Berücksichtigung der Belichtungszeit der simulierten Kamera dient.

Die synthetischen Kamerarohdaten 28 werden schließlich anhand einer geeigneten und dafür bereitgestellten Schnittstelle zur Einlesung durch den Prüfling 28 hinterlegt. Der Prüfling 28 verarbeitet die Kamerarohdaten 28 auf gleiche Weise, wie er es in einer echten Arbeitsumgebung mit echten Kamerarohdaten tun würde, und gibt infolge dieser Verarbeitung als Reaktion auf die synthetischen Kamerarohdaten 28 Steuerdaten 30 aus. Anhand der Steuerdaten 30 kann ein Fachmann eine Evaluierung des Verhaltens des Prüflings 28 vornehmen, indem er die Reaktion des Prüflings auf die synthetischen Kamerarohdaten 30 mit einer gewünschten Reaktion abgleicht.

Die Steuerdaten 30 können optional zur Einlesung durch die Szenensimulation 2 bereitgestellt werden (dargestellt durch einen gestrichelten Pfeil), damit diese die Steuerdaten in der Szenensimulation 2 berücksichtigen kann. Beispielsweise kann die Szenensimulation 2 auf ein anhand der Steuerdaten 30 angefordertes Wecksignal mit einer dazu passenden Animation des Fahrers 44 reagieren, indem sie die geschlossenen Augen des Fahrers 44 wieder öffnet und seinen Kopf wieder in eine aufrechte Position überführt.

## Patentansprüche

1. Computerimplementiertes Verfahren zur Erzeugung synthetischer Kameradaten (26), die folgenden Verfahrensschritte umfassend:

Rendering (6) einer Abbildung einer virtuellen Szenerie (42) und Hinterlegung von Farbinformation (12) zumindest eines Flächenelements (34) der virtuellen Szenerie (42) in Form von Farbraumkoordinaten eines Multistimulus-Farbraums;

Zuordnung einer Anzahl von Basisfunktionen, die jeweils eine relative Wellenlängenverteilung eines von dem Flächenelement (34) ausgestrahlten Lichtanteils beschreiben, zu dem Flächenelement (34), und Modellierung einer spektralen Strahldichte (22) des von dem Flächenelement (34) ausgestrahlten Lichts als Linearkombination der Basisfunktionen;

Herleitung der Skalierungsfaktoren der Basisfunktionen in der Linearkombination durch eine Verrechnung der spektralen Strahldichte (22) mit zumindest einer Farbraumkoordinate aus der Farbinformation (12) des Flächenelements und zumindest einer der Farbraumkoordinate zugeordneten Farbabgleichsfunktion;

Berechnung der spektralen Strahldichte (22) durch Einsetzen der Skalierungsfaktoren; und

Berechnung der synthetischen Kameradaten (26) mittels einer Verarbeitung der spektralen Strahldichte (22) in einer Kamerasimulation (4) einer in der virtuellen Szenerie (42) angeordneten Kamera (32).

2. Verfahren gemäß Anspruch 1, in dem eine der Basisfunktionen einen spektralen Verlauf einer Ausleuchtung (14) des Flächenelements (34) und ein Reflexionsspektrum (16) des Flächenelements (34) berücksichtigt.

3. Verfahren gemäß Anspruch 2, in dem dem Flächenelement (34) ein Materialattribut (10) zugeordnet ist und das Reflexionsspektrum (16) dem Materialattribut (10) zugeordnet ist.

4. Verfahren gemäß Anspruch 1, die folgenden Verfahrensschritte umfassend:

Vorberechnung von zur Herleitung der Skalierungsfaktoren zu lösenden Integralen;

Start einer Szenensimulation (2) einer zeitlichen Entwicklung der virtuellen Szenerie (42) nach Abschluss der Vorberechnung der Integrale, die Szenensimulation (2) umfassend einen wiederholten Durchlauf der Verfahrensschritte des Anspruchs 1,

wobei die Abbildung der virtuellen Szenerie (42) in jedem Durchlauf einen momentanen Zustand der virtuellen Szenerie (42) abbildet

und die synthetischen Kameradaten (26) in jedem Durchlauf mittels der vorberechneten Integrale berechnet werden.

5. Verfahren nach einem der vorhergehenden Ansprüche, umfassend den Verfahrensschritt: Berechnung der Farbraumkoordinaten (12) unter Berücksichtigung einer räumlichen Ausrichtung des Flächenelements (34) in Relation zu der Kamera (32), insbesondere eines Winkels zwischen einer Verbindungsgeraden (40) der Kamera zu dem Flächenelement (34) und einer Flächennormalen (38) des Flächenelements (34).

6. Verfahren nach einem der vorhergehenden Ansprüche, in dem die spektrale Strahldichte (22) derart berechnet wird, dass die spektrale Strahldichte (22) Wellenlängen außerhalb des sichtbaren Spektralbereichs umfasst, insbesondere Wellenlängen unterhalb von 380 Nanometern oder oberhalb von 780 Nanometern.

7. Verfahren nach einem der vorhergehenden Ansprüche, in dem die synthetischen Kameradaten (26) unter Berücksichtigung einer Quanteneffizienz eines simulierten Bildsensors der Kamera (32) als synthetische Kamerarohdaten berechnet werden.

8. Verfahren gemäß einem der vorhergehenden Ansprüche, mit dem Verfahrensschritt: Einlesung und Verarbeitung der synthetischen Kameradaten (26) durch zumindest eine Komponente eines zur Verarbeitung der Kameradaten ausgestalteten elektronischen Systems (28) zum Training des elektronischen Systems (28) oder zur Evaluierung einer Reaktion des elektronischen Systems (28) auf die synthetischen Kameradaten (26).

9. Verfahren gemäß Anspruch 8, umfassend die Merkmale des Anspruchs 6, in dem das elektronische System (28) ein Assistenzsystem ist, das vorgesehen ist, zur Überwachung eines Zustands einer Person (44), insbesondere einer ein Fahrzeug oder eine Maschine bedienenden Person (44), Kameradaten von einer Kamera auszuwerten, die auf die Person (44) gerichtet ist und Wellenlängen außerhalb des sichtbaren Spektralbereichs erfassen kann;

in dem die virtuelle Szenerie (42) eine virtuelle Repräsentation der Person (44) und die Abbildung der virtuellen Szenerie (42) eine Abbildung der Person (44) umfasst.

10. Verfahren gemäß Anspruch 9, umfassend die Merkmale des Anspruchs 2, in dem der spektrale Verlauf der Ausleuchtung eine infrarote oder ultraviolette Ausleuchtung der bedienenden Person (44) nachbildet.

11. Computerprogrammprodukt, das Mittel zur Durchführung eines Verfahrens gemäß einem der Ansprüche 1 bis 10 umfasst.

12. Computersystem, umfassend:

Mittel zur Berechnung synthetischer Kameradaten (26) durch ein Verfahren gemäß einem der Ansprüche 1 bis 10;

eine Schnittstelle zur Bereitstellung der synthetischen Kameradaten (26) zur Einlesung und Verarbeitung durch zumindest eine Komponente eines zur Verarbeitung der Kameradaten (26) ausgestalteten elektronischen Systems (28).

Fig. 1

Fig. 2

Fig. 3

Europäisches
Patentamt
European
Patent Office
Office européen
des brevets

# EUROPÄISCHER RECHERCHENBERICHT

Nummer der Anmeldung

EP 25 15 3316

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | MARK S. PEERCY ET AL: "Linear color representations for efficient image synthesis", COLOR RESEARCH & APPLICATION, Bd. 21, Nr. 2, 1. April 1996 (1996-04-01), Seiten 129-137, XP055624357, US ISSN: 0361-2317, DOI: 10.1002/(SICI)1520-6378(199604)21:2<129::A ID-COL7>3.0.CO;2-W | 1-3,5,6, 8-12 | INV. G06T15/50 G05B19/418 G02B27/00 |
| A | * das ganze Dokument * | 4,7 | |
| | ----- | | |
| A,D | JOYCE E FARRELL ET AL: "Digital camera simulation", APPLIED OPTICS, OPTICAL SOCIETY OF AMERICA, WASHINGTON, DC, US, Bd. 51, Nr. 4, 1. Februar 2012 (2012-02-01), Seiten A80-A90, XP001572773, ISSN: 0003-6935, DOI: 10.1364/AO.51.000A80 [gefunden am 2012-02-01] * das ganze Dokument * | 1-12 | |
| | ----- | | RECHERCHIERTE SACHGEBIETE (IPC) |
| A | PEERCY MARK S ED - ASSOCIATION FOR COMPUTING MACHINERY: "Linear color representations for full speed spectral rendering", COMPUTER GRAPHICS PROCEEDINGS. SIGGRAPH 99; [COMPUTER GRAPHICS PROCEEDINGS. SIGGRAPH], ACM ? - NEW YORK, NY, USA, 1515 BROADWAY, 17TH FLOOR NEW YORK, NY 10036 USA, 1. September 1993 (1993-09-01), Seiten 191-198, XP059029460, DOI: 10.1145/166117.166142 ISBN: 978-0-201-48560-8 * Zusammenfassung * | 1-12 | G06T G05B G02B |
| | ----- | | |

Der vorliegende Recherchenbericht wurde für alle Patentansprüche erstellt

| Recherchenort | Abschlußdatum der Recherche | Prüfer |
|---|---|---|
| München | 16. Juni 2025 | Rimassa, Simone |

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5710876 A

**In der Beschreibung aufgeführte Nicht-Patentliteratur**

- **JOYCE FARREL** ; **PETER CATRYSSE** ; **BRAN WANDELL**. Digital Camera Simulation. *Applied Optics*, vol. 51 (4), 2012

- **RENÉ MOLENAAR et al.** Full Spectrum Camera Simulation for Reliable Virtual Development and Validation of ADAS and Automated Driving Application. *IEEE Intelligent Vehicles Symposium*, 2015, vol. IV